(19) Europäisches Patentamt
European Patent Office
Office européen des brevets

(11) **EP 2 402 780 A1**

(12) **EUROPEAN PATENT APPLICATION**

(43) Date of publication:
**04.01.2012 Bulletin 2012/01**

(51) Int Cl.:
**G01R 33/565** $^{(2006.01)}$

(21) Application number: **10167034.7**

(22) Date of filing: **23.06.2010**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**
Designated Extension States:
**BA ME RS**

(71) Applicants:
• **Koninklijke Philips Electronics N.V.**
**5621 BA Eindhoven (NL)**

• **Philips Intellectual Property & Standards GmbH**
**20099 Hamburg (DE)**

(72) Inventor: **Eggers, Holger**
**5600 AE Eindhoven (NL)**

(74) Representative: **Damen, Daniel Martijn**
**P.O. Box 220**
**5600 AE Eindhoven (NL)**

(54) **Method of reconstructing a magnetic resonance image of an object considering higher-order dynamic fields**

(57)     The invention relates to a method of acquiring a magnetic resonance image of an object employing spatial encoding by a gradient field, said gradient field comprising non-linear gradient field components, the method comprising:

- selecting (100) a limited set of spatially variant basis functions for describing the gradient field including the non-linear gradient field components by linear combinations of said basis functions,
- determining (102) the temporally variant weights of the basis functions for said linear combinations,
- acquiring (104) magnetic resonance data of the object (10),
- embedding (106) the acquired magnetic resonance data into a multi-dimensional space, wherein the number of dimensions is given by the number of selected basis functions,
- transforming (110) the acquired magnetic resonance data in this multi-dimensional space from the measurement domain to the image domain,
- calculating (112) the desired magnetic resonance image of the object (10) from this transformed multi-dimensional space by linear combinations along the surplus dimensions.

Fig 2

**Description**

FIELD OF THE INVENTION

Image-forming MR methods, which utilize the interaction between magnetic field and nuclear spins in order to form two-dimensional or three-dimensional images are widely used nowadays, notably in the field of medical diagnostics, because for the imaging of soft tissue they are superior to other imaging methods in many respects, they do not require ionizing radiation, and they are usually not invasive.

BACKGROUND OF THE INVENTION

According to the MR method in general, the body of a patient or in general an object to be examined is arranged in a strong, uniform magnetic field $B_0$ whose direction at the same time defines an axis, normally the z-axis, of the coordinate system on which the measurement is based.

The magnetic field produces different energy levels for the individual nuclear spins in dependence on the applied magnetic field strength. These nuclear spins can be excited (spin resonance) by application of an alternating electromagnetic field (RF field) of defined frequency, the so called Larmor frequency or MR frequency. From a macroscopic point of view the distribution of the individual nuclear spins produces an overall magnetization which can be deflected out of the state of equilibrium by application of an electromagnetic pulse of appropriate frequency (RF pulse) whose magnetic field extends perpendicularly to the z-axis, so that the magnetization performs a precessional motion about the z-axis.

Any variation of the magnetization can be detected by means of receiving RF antennas, which are arranged and oriented within an examination volume of the MR device in such a manner that the variation of the magnetization is measured in a direction perpendicularly to the z-axis.

In order to realize spatial resolution in the body, constant magnetic field gradients extending along the three main axes are superposed on the uniform magnetic field, leading to a linear spatial dependency of the spin resonance frequency. The signal picked up in the receiving antennas then contains components of different frequencies which can be associated with different locations in the body.

The signal data obtained via the receiving antennas correspond to the spatial frequency domain and are called k-space data. The k-space data usually include multiple lines acquired with different phase encoding. Each line is digitized by collecting a number of samples. A set of samples of k-space data is converted to an MR image, e.g. by means of a Fourier transformation.

Magnetic resonance imaging usually relies on constant gradients, i.e. linear variations over space, of the magnetic field for spatial encoding of the received signal. However, these constant gradients entail according to Maxwell's equations non-constant gradients, i.e. non-linear variations over space, of the magnetic field, which can be predicted by theory. These non-constant gradients have been coined Maxwell or concomitant gradients. In addition, temporal variations of constant gradients, as they are performed in basically any acquisition sequence, give rise to eddy currents, which can be considered as non-constant gradients, which also evolve over time. These non-constant gradients can to a certain extent be predicted by system modeling, or they can be measured with high accuracy (Barmet C, De Zanche N, Pruessmann KP. Spatiotemporal magnetic field monitoring for MR. Magn Reson Med 2008; 60:187-197).Both types of non-constant gradients, which are also called higher-order dynamic fields, lead to a distortion of the Fourier encoding and thus to artifacts in resulting images, since they are commonly neglected in reconstruction today

Recently, the basic feasibility of considering, i.e. not neglecting, higher-order dynamic fields in reconstruction has been shown, and associated improvements in image quality have been demonstrated using a brute-force approach to reconstruction (Wilm BJ, Barmet C, Pavan M, Boesiger P, Pruessmann KP. Integration of higher-order dynamic fields into MR reconstruction. Proc ISMRM 2009; 562). However, making no assumption on the structure of the encoding matrix, which links the acquired data with the unknown image, leads to a very large linear system of equations. Solving it is prohibitively complex for clinical applications to date.

Moreover, the deliberate use of non-constant gradients for spatial encoding has been considered lately, which leads to similar problems in image reconstruction.

From the foregoing it is readily appreciated that there is a need for an improved method of reconstructing a magnetic resonance image of an object employing spatial encoding considering higher-order dynamic fields. It is consequently an object of the invention to provide such a method.

SUMMARY OF THE INVENTION

In accordance with the invention, a method of acquiring a magnetic resonance image of an object employing spatial encoding by a gradient field is provided, wherein said gradient field comprises non-linear gradient field components, wherein the method comprises selecting a limited set of spatially variant basis functions for describing the gradient field including the non-linear gradient field components by linear combinations of said basis functions. The method further comprises determining the temporally variant weights of the basis functions for said linear combinations, acquiring magnetic resonance data of the object and embedding the acquired magnetic resonance data into a multi-dimensional space, wherein the number of dimensions is given by the number of selected basis functions, and transforming the acquired magnetic resonance data in this multi-dimensional space from the measurement domain to the image domain. Finally the desired magnetic resonance image of the object is calculated from this transformed multi-dimensional space by linear combinations along the surplus dimensions.

Embodiments of the invention have the advantage that higher-order dynamic fields can be considered in reconstruction without increasing computation times prohibitively or requiring expensive, high performance computational clusters. Consequently, image quality can be improved in clinical applications, for instance in diffusion weighted imaging, or non-constant gradient fields can be exploited for spatial encoding.

It has to be noted, that the method can be applied to a multitude of different applications. For example, the effect of Maxwell or concomitant gradients (in particular in combination with a theoretical mathematical modeling of them) can be corrected. It is further possible to perform a correction of undesired non-linear gradient field components (in particular arising from eddy currents caused by switching the desired linear gradients field for imaging). Finally, reconstruction of images is possible even when spatial encoding is deliberately performed with non-linear gradient field components.

In accordance with a further embodiment of the invention, transforming the acquired magnetic resonance data further comprises resampling the acquired magnetic resonance data on equidistantly spaced grid points in the multi-dimensional space and applying fast Fourier transforms (FFTs).

Resampling on equidistantly spaced grid points enables the usage of fast Fourier transforms which significantly speed up the calculation process of the desired final magnetic resonance image. For example, the resampling of the acquired magnetic resonance data may be performed with a convolution interpolation (so-called gridding) or a min-max interpolation process (Eggers H, Knopp T, Potts D. Field inhomogeneity correction based on gridding reconstruction for magnetic resonance imaging. IEEE Trans Med Imaging 2007; 26:374-384).

In accordance with a further embodiment of the invention, the basis functions are spherical harmonics. This permits to employ well developed mathematical approaches for describing the gradient field including the non-linear gradient field components by linear combinations of said basis functions which further permits optimizing all calculations for obtaining the desired final magnetic resonance image.

The inhomogeneity of the static magnetic field may additionally be considered by approximating it with usually one basis function.

In accordance with a further embodiment of the invention, the basis functions are chosen in such a way that a given approximation accuracy is attained with the least number of basis functions. Thus, data processing time is kept at the lowest possible level.

In accordance with a further embodiment of the invention, determining the temporally variant weights of the basis functions comprises a theoretical modeling of the non-linear gradient field components, and/or an experimental measurement of the non-linear gradient field components, either directly or indirectly via their effect on the magnetic resonance signal picked up from defined probes.

In another aspect, the invention relates to a computer program product comprising computer executable instructions to perform the method of any of the previous claims.

In another aspect, the invention relates to a magnetic resonance imaging system for acquiring a magnetic resonance image of an object employing spatial encoding by a gradient field, said gradient field comprising non-linear gradient field components, wherein the system is adapted for:

- selecting a limited set of spatially variant basis functions for describing the gradient field including the non-linear gradient field components by linear combinations of said basis functions,
- determining the temporally variant weights of the basis functions for said linear combinations,
- acquiring magnetic resonance data of the object,
- embedding the acquired magnetic resonance data into a multi-dimensional space, wherein the number of dimensions is given by the number of selected basis functions,
- transforming the acquired magnetic resonance data in this multi-dimensional space from the measurement domain to the image domain,
- calculating the desired magnetic resonance image of the object from this transformed multi-dimensional space by linear combinations along the surplus dimensions.

BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:

Fig. 1 shows an MR device for implementation of the method according to the invention,
Fig. 2 shows a flowchart illustrating method steps of the invention.

DETAILED DESCRIPTION OF THE EMBODIMENTS

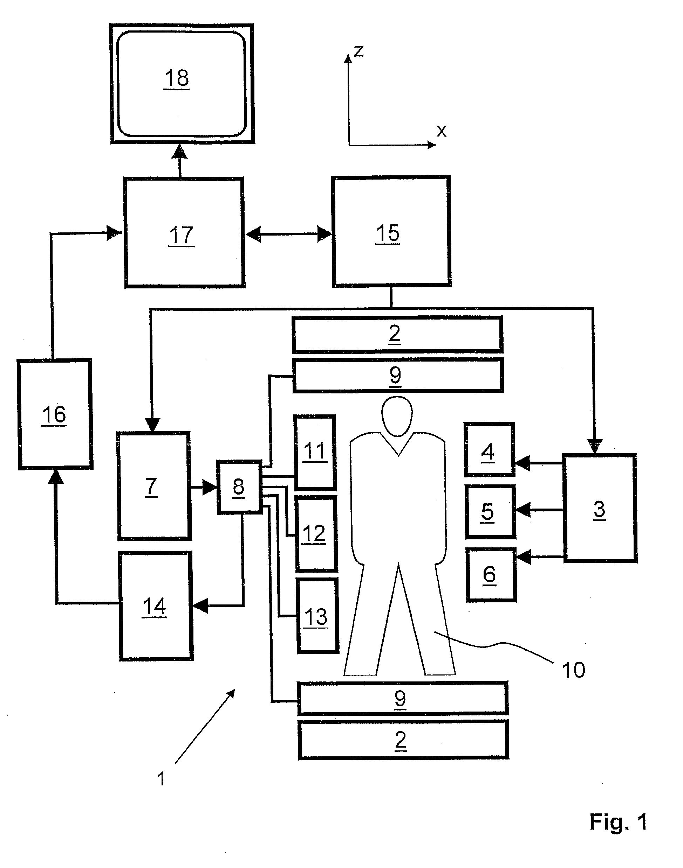

With reference to Fig. 1, an MR imaging system 1 is shown. The system comprises superconducting or resistive main magnet coils 2 such that a substantially uniform, temporally constant main magnetic field $B_0$ is created along a z-axis through an examination volume.

A magnetic resonance generation manipulation system applies a series of RF pulses and switched magnetic field gradients to invert or excite nuclear magnetic spins, induce magnetic resonance, refocus magnetic resonance, manipulate magnetic resonance, spatially or otherwise encode the magnetic resonance, saturate spins and the like to perform MR imaging.

More specifically, a gradient pulse amplifier 3 applies current pulses to selected ones of whole body gradient coils 4, 5 and 6 along x, y and z-axes of the examination volume. An RF transmitter 7 transmits RF pulses or pulse packets, via a send/receive switch 8 to an RF antenna 9 to transmit RF pulses into the examination volume. A typical MR imaging sequence is composed of a packet of RF pulse sequences of short duration which taken together with any applied magnetic field gradients achieve a selected manipulation of nuclear magnetic resonance. The RF pulses are used to saturate resonance, excite resonance, invert magnetization, refocus resonance, or manipulate resonance and select a portion of a body 10 positioned in the examination volume. The MR signals may also be picked up by the RF antenna 9.

For generation of MR images of limited regions of the body or in general object 10, for example by means of parallel imaging, a set of local array RF coils 11, 12 and 13 are placed contiguous to the region selected for imaging. The array coils 11, 12 and 13 can be used to receive MR signals induced by RF transmissions effected via the RF antenna. However, it is also possible to use the array coils 11, 12 and 13 to transmit RF signals to the examination volume.

The resultant MR signals are picked up by the RF antenna 9 and/or by the array of RF coils 11, 12 and 13 and are demodulated by a receiver 14 preferably including a pre-amplifier (not shown). The receiver 14 is connected to the RF coils 9, 11, 12 and 13 via a send/receive switch 8.

A host computer 15 controls the gradient pulse amplifier 3 and the transmitter 7 to generate any of a plurality of imaging sequences, such as echo planar imaging (EPI), echo volume imaging, gradient and spin echo imaging, fast spin echo imaging and the like.

For the selected sequence, the receiver 14 receives a single or a plurality of MR data lines in a rapid succession following each RF excitation pulse. A data acquisition system 16 performs analogue to digital conversion of the received signals and converts each MR data line to a digital format suitable for further processing. In modem MR devices the data acquisition system 16 is a separate computer which is specialized in acquisition of raw image data.

Ultimately, the digital raw image data is reconstructed into an image representation by a reconstruction processor 17 which applies a Fourier transform or other appropriate reconstruction algorithms. The MR image may represent a planar slice through the patient, an array of parallel planar slices, a three-dimensional volume or the like. The image is then stored in an image memory where it may be accessed for converting slices or other portions of the image representation into appropriate formats for visualization, for example via a video monitor 18 which provides a man readable display of the resultant MR image.

The reconstruction processor 17 may be adapted for carrying out the respective mathematical calculations of the inventive method mentioned above to determine the final desired magnetic resonance image of the object 10.

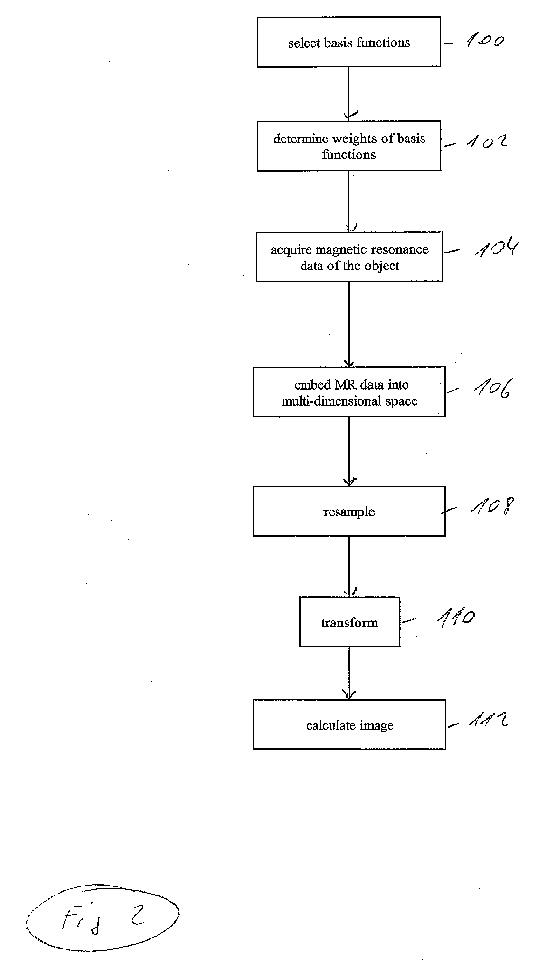

Fig. 2 is a flowchart illustrating method steps of the invention. The method starts in step 100 with selecting a limited set of spatially variant basis functions for describing the gradient field including the non-linear gradient field components by linear combinations of said basis functions. This is followed by step 102, in which the temporally variant weights of the basis functions for said linear combinations are determined.

Here, various possibilities exist for said determination. Determining the temporally variant weights of the basis functions may comprise a theoretical modeling of the non-linear gradient field components, and/or an experimental measurement of the non-linear gradient field components, either directly or indirectly via their effect on the magnetic resonance signal picked up from defined probes, as suggested in Wilm BJ, Barmet C, Pavan M, Boesiger P, Pruessmann KP. Integration of higher-order dynamic fields into MR reconstruction. Proc ISMRM 2009; 562.

Thus, in steps 100 and 102 the dynamic, i.e. non-static, contributions to the $B_0$ field at a spatial location r at a time point t are modeled by the sum of $N$ products of temporally varying coefficients $k_n$ and spatially varying basis functions $b_n$. The set of basis functions $b_n$ is preferably selected such that the dynamic contributions to the $B_0$ field may be described with sufficient accuracy with as few basis functions as possible. The set of coefficients $k_n$ is obtained either analytically or experimentally. For an analytical calculation, the assumed temporally varying gradients field, which are intentionally or unintentionally applied during the measurement, are integrated over time. For an experimental determination, the phase accrued in samples at defined spatial locations is measured, and the set of coefficients $k_n$ is derived by fitting the sum of $N$ products of these coefficients $k_n$ and the basis functions $b_n$ to this phase.

After the MR data acquisition process in step 104, which may take place concurrently with or subsequent to the previously mentioned experimental measurement of the non-linear gradient field components, and in which magnetic resonance data of the object to be imaged are acquired, said acquired magnetic resonance data are embedded into a multi-dimensional space, wherein the number of dimensions is given by the number of selected basis functions (step 106). In other words, in step 106 the acquired samples are embedded into a multi-dimensional space (which may be considered as an extension of the well-known k-space), where the number of dimensions is given by the cardinality of the chosen set of basis functions.

Thus, given a (void) $N$-dimensional space, the complex sample acquired at time point $t$ is placed at coordinate $(k_1(t), k_2(t), ..., k_n(t))$ in this space. Due to the higher dimensionality of this space, the samples acquired typically fill this space only very sparsely.

In order to permit a subsequent fast Fourier transform process of the acquired image data, in step 108 the acquired magnetic resonance data are resampled onto equidistantly spaced grid points in the multi-dimensional space. For example, resampling of the acquired magnetic resonance data is performed with a gridding or a min-max interpolation process.

In case of gridding, the reconstruction process involves an optional weighting of the acquired samples, a convolution of the result with a window function and a sampling on a Cartesian grid in the multi-dimensional space, a transformation of the result to the image domain with FFTs, and finally a weighting of the result (compare for example Eggers H, Knopp T, Potts D. Field inhomogeneity correction based on gridding reconstruction for magnetic resonance imaging. IEEE Trans Med Imaging 2007; 26:374-384).

After data resampling in step 108, the acquired magnetic resonance data in the multi-dimensional space are transformed in step 110 from the measurement domain to the image domain, for example by applying fast Fourier transforms.

Finally, in step 112 the desired magnetic resonance image of the object is calculated by linear combinations along the surplus dimensions in this transformed multi-dimensional space. For example, a (local) linear combination of the data in the image domain (which may be considered as a projection) may be performed in order to obtain a reconstructed 2D image or 3D volume.

In the following, a detailed mathematical outline of the above discussed method shall be given for deeper understanding of the method.

Following the model introduced in Barmet C, De Zanche N, Pruessmann KP. Spatiotemporal magnetic field monitoring for MR. Magn Reson Med 2008; 60:187-197, the encoding of the received signal $s$ is described by

$$s = Em,$$

where m denotes the sought image and E denotes the encoding matrix. The elements of the latter are given by

$$E_{xp} = e^{-i\sum_n k_n(t_k) b_n(r_Q)},$$

where k denotes a phase coefficient (or a temporally variant weight) and b denotes a spatially variant basis function. Using an expansion into spherical harmonics, the basis functions of zeroth and first order are

$$b_0(r_p) = 1,$$

$$b_1(r_p) = x,$$

$$b_2(r_p) = y \, ,$$

$$b_3(r_p) = z \, ,$$

ignoring scaling factors. Any higher orders are commonly neglected, thus permitting the application of standard gridding for reconstruction. The elements of the encoding matrix reduce to

$$E_{xp} = e^{-ik_0(t_k)} e^{-i(k_1(t_k)x + k_2(t_k)y + k_3(t_k)z))}$$

in this case, which allows a separation into

$$E = D'E'$$

with

$$D'_k = e^{-ik_0(t_k)} \, ,$$

$$E'_{xp} = e^{-ik_x r_p} \, ,$$

where $k$ denotes the conventional $k$-space vector. In contrast to $r$, the latter is typically not sampled equidistantly, either intentionally or unintentionally due to system imperfections.

The basis functions of second order are

$$b_4(r_p) = xy \, ,$$

$$b_5(r_p) = zy \, ,$$

$$b_6(r_p) = 3z^2 - (x^2 + y^2 + z^2) \, ,$$

$$b_7(r_p) = xz \, ,$$

$$b_8(r_p) = x^2 - y^2 \, .$$

They, as all of higher order, prevent an application of standard gridding for reconstruction, since they depend non-linearly on x, y, or z. Generally, it is sufficient to provide an efficient multiplication of a vector of voxels with the encoding matrix and of a vector of samples with the Hermetian encoding matrix to obtain an efficient reconstruction, be it direct or iterative.

It has been shown for field inhomogeneity correction (Eggers H, Knopp T, Potts D. Field inhomogeneity correction based on gridding reconstruction for magnetic resonance imaging. IEEE Trans Med Imaging 2007; 26:374-384) that the concept of gridding may be generalized to arbitrary sampling in both domains.

Now the data in both domains are embedded in a higher dimensional space, where the dimension is given by the number of basis functions. For each dimension, two constants $N$ and $T$ are chosen such that

$$\frac{k_n(t_k)b_n(r_p)}{2\pi} \in \left[ -\frac{N_n}{4} + \frac{\mu}{2\alpha}, \frac{N_n}{4} - \frac{\mu}{2\alpha} \right],$$

$$\frac{k_n(t_k)}{T_n} \in \left[ -\frac{1}{2} + \frac{\mu}{\alpha N_n}, +\frac{1}{2} - \frac{\mu}{\alpha N_n} \right],$$

where [$\mu$ denotes the gridding kernel size, and $\alpha$ denotes the gridding oversampling factor. To minimize $N_n$, both $k$ and $b$ should be centered. We restrict us for the moment to the first basis function of second order and the multiplication of a vector of voxels with the encoding matrix.

Modifying the approximation established in H, Knopp T, Potts D. Field inhomogeneity correction based on gridding reconstruction for magnetic resonance imaging. IEEE Trans Med Imaging 2007; 26:374-384,

$$e^{2\pi ikx} \approx \frac{1}{\alpha N \hat{\varphi}(x)} \sum_{l=-\frac{\alpha N}{2}}^{\frac{\alpha N}{2}-1} \psi\left( k - \frac{l}{\alpha N} \right) e^{2\pi i \frac{lx}{\alpha N}},$$

where $\alpha$ denotes a real oversampling factor, $\varphi$ denotes a window function, $\psi$ denotes its truncation, and ^ indicates the Fourier transform, to

$$e^{-ik_{4k}xy} = e^{-2\pi i \frac{k_{4k}xyT}{T}\frac{1}{2\pi}} \approx \frac{1}{\alpha N_4 \hat{\varphi}\left( -\frac{xyT}{2\pi} \right)} \sum_{l=-\frac{\alpha N_4}{2}}^{\frac{\alpha N_4}{2}-1} \psi\left( \frac{k_{4k}}{T} - \frac{1}{\alpha N_4} \right) e^{-i\frac{xyTl}{\alpha N_4}},$$

it is obtained that

$$\sum_{x,y,z} m_{x,y,z} e^{-ik_{0k}} e^{-i(k_{1k}x+k_{2k}y+k_{2x}z)} e^{-ik_{4k}xy} \approx$$

$$e^{-ik_{0k}} \frac{1}{\alpha N_4 \hat{\varphi}\left( -\frac{xyT}{2\pi} \right)} \sum_{l=-\alpha N_4/2}^{\alpha N_4/2-1} \psi\left( \frac{k_{4k}}{t} - \frac{l}{\alpha N_4} \right) \sum_{x,y,z} m_{x,y,z} e^{-i\frac{xyTl}{\alpha N_4}} e^{-i(k_{1k}x+k_{2k}y+k_{3k}z)}.$$

Thus, $m$ has to be weighted in the spatial domain, transformed for each $l$ to the frequency domain, and convolved in the frequency domain. The overall complexity of reconstruction essentially grows by the product of all $N_n$ with $n > 3$

$$0((\Pi_{n=4}^{L}\alpha N_{n})N_{x}N_{y}N_{z}(\log(N_{x})+\log(N_{y})+\log(N_{z}))),$$

where L+1 equals the number of considered basis functions. For small deviations from ideal constant gradients, this constitutes a substantial reduction compared to a brute-force evaluation of the matrix-vector product

$$0(N_{x}^{2}N_{y}^{2}N_{z}^{2}).$$

It is possible to pick individual basis functions, whose contribution is considered significant. It is, for instance, not necessary to include all basis functions of a certain order or up to a certain order. Static main field inhomogeneity can be considered separately in all of the described approaches. So-called Maxwell fields or concomitant fields can easily be modeled with the employed expansion into spherical harmonics as well. Min-max interpolation may be an interesting alternative to gridding, especially for small $N_{n}$.

**Claims**

1.  A method of acquiring a magnetic resonance image of an object (10) employing spatial encoding by a gradient field, said gradient field comprising non-linear gradient field components, the method comprising:

    - selecting (100) a limited set of spatially variant basis functions for describing the gradient field including the non-linear gradient field components by linear combinations of said basis functions,
    - determining (102) the temporally variant weights of the basis functions for said linear combinations,
    - acquiring (104) magnetic resonance data of the object (10),
    - embedding (106) the acquired magnetic resonance data into a multi-dimensional space, wherein the number of dimensions is given by the number of selected basis functions,
    - transforming (110) the acquired magnetic resonance data in this multi-dimensional space from the measurement domain to the image domain,
    - calculating (112) the desired magnetic resonance image of the object (10) from this transformed multi-dimensional space by linear combinations along the surplus dimensions.

2.  The method of claim 1, wherein transforming the acquired magnetic resonance data further comprises resampling (108) the acquired magnetic resonance data on equidistantly spaced grid points in the multi-dimensional space and applying fast Fourier transforms.

3.  The method of claim 2, wherein the resampling of the acquired magnetic resonance data is performed with a gridding, a convolution interpolation, or a min-max interpolation process.

4.  The method of claim 1, wherein the basis functions are spherical harmonics.

5.  The method of claim 1, wherein one of the basis functions approximates the inhomogeneity of the static magnetic field.

6.  The method of claim 1, where the basis functions are chosen in such a way that a given approximation accuracy is attained with the least number of basis functions.

7.  The method of claim 1, wherein determining the temporally variant weights of the basis functions comprises a theoretical modeling of the non-linear gradient field components, and/or an experimental measurement of the non-linear gradient field components, either directly or indirectly via their effect on the magnetic resonance signal picked up from defined probes.

8.  A computer program product comprising computer executable instructions to perform the method of any of the previous claims.

9.  A magnetic resonance imaging system (1) for acquiring a magnetic resonance image of an object (10) employing spatial encoding by a gradient field, said gradient field comprising non-linear gradient field components, wherein the system is adapted for:

- selecting (100) a limited set of spatially variant basis functions for describing the gradient field including the non-linear gradient field components by linear combinations of said basis functions,
- determining (102) the temporally variant weights of the basis functions for said linear combinations,
- acquiring (104) magnetic resonance data of the object (10),
- embedding (106) the acquired magnetic resonance data into a multi-dimensional space, wherein the number of dimensions is given by the number of selected basis functions,
- transforming (110) the acquired magnetic resonance data in this multi-dimensional space from the measurement domain to the image domain,
- calculating (112) the desired magnetic resonance image of the object (10) from this transformed multi-dimensional space by linear combinations along the surplus dimensions.

**Fig. 1**

```
┌─────────────────────────┐
│  select basis functions │ ─ 100
└─────────────────────────┘
             │
             ▼
┌─────────────────────────┐
│ determine weights of basis │ ─ 102
│        functions        │
└─────────────────────────┘
             │
             ▼
┌─────────────────────────┐
│ acquire magnetic resonance │ ─ 104
│     data of the object  │
└─────────────────────────┘
             │
             ▼
┌─────────────────────────┐
│     embed MR data into  │ ─ 106
│  multi-dimensional space │
└─────────────────────────┘
             │
             ▼
┌─────────────────────────┐
│        resample         │ ─ 108
└─────────────────────────┘
             │
             ▼
┌─────────────────────────┐
│        transform        │ ─ 110
└─────────────────────────┘
             │
             ▼
┌─────────────────────────┐
│     calculate image     │ ─ 112
└─────────────────────────┘
```

Fig 2

Europäisches
Patentamt

European
Patent Office

Office européen
des brevets

# EUROPEAN SEARCH REPORT

Application Number

EP 10 16 7034

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | HOLGER EGGERS ET AL: "Field Inhomogeneity Correction Based on Gridding Reconstruction for Magnetic Resonance Imaging" IEEE TRANSACTIONS ON MEDICAL IMAGING, IEEE SERVICE CENTER, PISCATAWAY, NJ, US LNKD-DOI:10.1109/TMI.2006.891502, vol. 26, no. 3, 1 March 2007 (2007-03-01), pages 374-384, XP011171973 ISSN: 0278-0062 * see chapter 'II. Theory' * ----- | 1-9 | INV. G01R33/565 |
| X,D | B.J.WILM ET AL.: "Integration of higher-order dynamic fields into MR image reconstruction" PROC.INTL.SOC.MAG.RESON.MED. 17, 2009, page 563, XP002598419 * the whole document * ----- | 1,4-9 | |
| X | SUTTON B P ET AL: "FAST, ITERATIVE IMAGE RECONSTRUCTION FOR MRI IN THE PRESENCE OF FIELD INHOMOGENETEITIES" IEEE TRANSACTIONS ON MEDICAL IMAGING, IEEE SERVICE CENTER, PISCATAWAY, NJ, US LNKD-DOI:10.1109/TMI.2002.808360, vol. 22, no. 2, 1 February 2003 (2003-02-01), pages 178-188, XP001163204 ISSN: 0278-0062 * see chapter 'II. Theory' * ----- | 1,6,8,9 | TECHNICAL FIELDS SEARCHED (IPC) G01R |
| A | US 5 877 629 A (KING KEVIN F [US] ET AL) 2 March 1999 (1999-03-02) * see the chapter 'General Description of the Invention' * ----- | 1,4-9 | |

The present search report has been drawn up for all claims

| Place of search | Date of completion of the search | Examiner |
|---|---|---|
| Munich | 30 August 2010 | Lersch, Wilhelm |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 10 16 7034

This annex lists the patent family members relating to the patent documents cited in the above-mentioned European search report.
The members are as contained in the European Patent Office EDP file on
The European Patent Office is in no way liable for these particulars which are merely given for the purpose of information.

30-08-2010

| Patent document cited in search report | | Publication date | Patent family member(s) | Publication date |
|---|---|---|---|---|
| US 5877629 | A | 02-03-1999 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **BARMET C ; DE ZANCHE N ; PRUESSMANN KP.** Spatiotemporal magnetic field monitoring for MR. *Magn Reson Med,* 2008, vol. 60, 187-197
- **WILM BJ ; BARMET C ; PAVAN M ; BOESIGER P ; PRUESSMANN KP.** Integration of higher-order dynamic fields into MR reconstruction. *Proc ISMRM,* 2009, 562

- **EGGERS H ; KNOPP T ; POTTS D.** Field inhomogeneity correction based on gridding reconstruction for magnetic resonance imaging. *IEEE Trans Med Imaging,* 2007, vol. 26, 374-384
- *MR. Magn Reson Med,* 2008, vol. 60, 187-197
- **H, KNOPP T ; POTTS D.** Field inhomogeneity correction based on gridding reconstruction for magnetic resonance imaging. *IEEE Trans Med Imaging,* 2007, vol. 26, 374-384